Europäisches Patentamt

European Patent Office

Office européen des brevets

(11) Publication number : **0 540 216 A1**

# (12) EUROPEAN PATENT APPLICATION

(21) Application number : **92309464.3**

(22) Date of filing : **16.10.92**

(51) Int. Cl.⁵ : **H03H 21/00**

(30) Priority : **01.11.91 GB 9123210**

(43) Date of publication of application :
**05.05.93 Bulletin 93/18**

(84) Designated Contracting States :
**DE FR IT NL**

(71) Applicant : **GEC-MARCONI LIMITED**
**The Grove, Warren Lane**
**Stanmore, Middlesex HA7 4LY (GB)**

(72) Inventor : **Maybank, Stephen John**
**1 Harborne Close**
**South Oxhey, Watford WD1 6TZ (GB)**

(74) Representative : **Keppler, William Patrick**
**Central Patent Department Wembley Office**
**The General Electric Company, p.l.c. Hirst**
**Research Centre East Lane**
**Wembley Middlesex HA9 7PP (GB)**

(54) **Filter.**

(57) A filter for deriving estimates of parameters representative of the state of a system comprises means for making a sequence of related measurements of the state over a period of time, and means responsive thereto for generating an approximation to the optimal probability density function of the system in the form of a product of a linear function and a Gaussian function or of a product of a polynomial function and a Gaussian function.

EP 0 540 216 A1

This invention relates to filter systems, and has a wide range of applications in science and technology, more especially in the field of signal processing, navigation and image analysis, and in particular computer vision. Filtering is widely used in computer vision to obtain good estimates of the parameters describing the state of a system such as camera velocity or camera orientation by combining estimates based on a sequence of measurements of the state accumulated over a period of time. The measurements are, however, subject to unknown errors and random perturbations collectively referred to as noise. The filter reduces the effects of the errors on the estimate of the system state. In order to do this the filter requires information about the distribution of the errors. In many applications including Computer vision the system parameters may vary with time.

The theoretical foundations of filtering are for the most part well understood. However it is still difficult to devise accurate filters which do not require unrealistically high levels of computation. The filter in accordance with the present invention provides a major step forward in the resolution of this problem, and is based on a modification of the well known state space approach to filtering to take account of random variations.

In principal the parameter estimation can be carried out optimally, in that there exists a filter which makes best possible use of all the available information. If the evolution of the system and the measurement process are both linear and subject to white Gaussian noise then the optimal filter is the well known Kalman filter. The Kalman filter is computationally tractable and relatively straightforward to implement. In the non-linear case the computational complexity of the optimal filter is usually so high that it precludes any practical implementation.

In accordance with the present invention a filter for deriving estimates of parameters describing the state of a system, comprises means for making a sequence of related measurements of the state over a period of time, and means responsive thereto for generating an approximation to the optimal probability density function of the system in the form of a product of a linear function and a Gaussian function or of a product of a polynomial function and a Gaussian function.

It can be shown that such a filter can provide a computational feasible approximation to the optimal filter, and has a guaranteed performance, even where the evolution and measurement process are non-linear. Thus if h is any smooth function defined on the state space $R^n$, let E(h) be the expected value of h obtained from the optimal filter and let $E_a(h)$ be the expected value of h obtained from the filter in accordance with the invention. It follows that

$$|E(h) - E_a(h)| = 0(\lambda^{-2}) \quad (1)$$

The parameter $\lambda$ is related to the noise level. If the noise level is low then $\lambda$ is large and $E_a(h)$ is close to E(h).

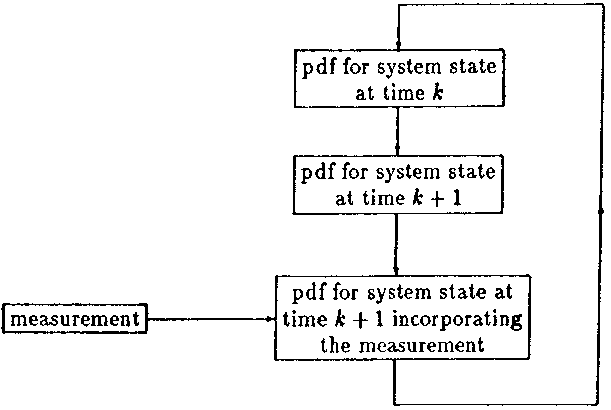

The filter in accordance with the invention is implemented within a general framework well established in the literature. The framework is summarised in the flow chart illustrated in the accompanying drawing.

The probability density function (pdf) summarises all the available information about the system state. The pdf at time k is propagated one time step to time k + 1 using the model of the time evolution of the system held in the filter. A measurement is obtained at time k + 1 and then incorporated into the pdf to give a new pdf for the system state at time k + 1. The cycle is then repeated.

The filter uses a novel approximation to the optimal probability density function. Preferably the approximating function is the product of a linear function and a Gaussian function. This choice of approximating function is made in order to obtain the asymptotic performance guarantee summarised in equation (1).

The filter contains a set of propagation equations which generate the approximation to the optimal pdf at time k + 1 given i) the approximation at time k; ii) the state propagation equation; and iii) the statistical properties of the noise affecting the state propagation.

Let the state space be a subset of the Euclidean space $R^n$, let $\lambda$ be the measure of the noise level introduced in (1), and let x be a general point of the state space. The approximating function M (P,u,m,x) to the optimal probability density function at time k is defined by

$$M_\lambda (P, \mu, m, x) = \left( \frac{\lambda^n}{(2\pi)^n \det(P)} \right)^{1/2} \left( 1 + \mu^T P^{-1}(x - m) \right) \exp \left( -\frac{\lambda}{2}(x - m)P^{-1}(x - m) \right)$$

The vectors $\mu$, m are n dimensional and P is a positive definite n x n matrix. Let the state evolution equation be

$$x \longmapsto f(x) + v$$

where f is a deterministic function and v is a random noise process with a probability density function approximated by

$$M_{\lambda s} (C, \mathcal{V}, 0, v)$$

Let the approximation to the optimal probability density function at time k + 1 after one step of the state evolution be

$$M_\lambda (B, \tau, n, x)$$

Then B, , n are given by the propagation equations

$$n = f(m) \quad (2)$$

$$B_{ij} = f_{im} f_{jl} P_{ml} + \lambda_s^{-1} \lambda C_{ij} \quad (3)$$

$$\tau_i = \frac{1}{2} f_{ijk} P_{jk} + f_{ij} N_j + \lambda_s^{-1} \lambda_{vi} \quad (4)$$

In the equations (2),(3),(4) the subscripts denoting derivatives are written on the right, and the subscripts denoting components are written on the left. The propagation equations are chosen to ensure that the pdf at time k + 1 contains sufficient information to allow the estimation of expected values to an accuracy of $0(\lambda^{-2})$. A similar set of update equations applies to any of the possible approximations to the optimal density, provided that they also preserve the ability to estimate expected values to an accuracy of $0(\lambda^{-2})$.

In the measurement update the information contained in a measurement is incorporated into the estimate of the optimal probability density function. Let $R^m$ be the measurement space and let z be a measurement. The measurement z is given in terms of the state x by

$$z = h(x) + w$$

where $h : R^n \to R^m$ is a deterministic function and w is a random noise process. The probability density function $p(x \mid z)$ incorporating the measurement is given in terms of the density $p_1(x)$ prior to the measurement and the conditional density $p_2(z \mid x)$ by equation

$$p(x \mid z) = c p_1(x) p_2(z \mid x)$$

where c is a normalising constant. The prior density is approximated by

$$p_1(x) = M_\lambda (B, \tau, n, x)$$

and the conditional density is approximated by

$$p_2(z \mid x) = M_\lambda (R, \Sigma, 0, z - h(x))$$

where R is the noise covariance.

Let $\psi : R^n \to R$ be defined by

$$\psi(x) = - \frac{\lambda_m}{2}(z - h(x))^T R^{-1}(z - h(x)) - \frac{1}{2}(x - n)^T B^{-1}(x - n)$$

The measurement update is carried out by first using a standard hill-climbing method to locate the maximum m of and then taking derivatives at m in order to compute the approximation $p(x \mid z)$ to the optimal probability density function.

Before incorporating the measurement a check is carried out to see if the proposed measurement update preserves the ability to estimate expected values to an accuracy of $0(\lambda^{-2})$. To do this the value of c is estimated using Gaussian approximations to $p_1(x)$ and $p_2(z \mid x)$. If c is $0(1)$ or smaller compared to $\lambda$ then the measurement update preserves the abiulity to estimate expected values to an accuracy of $0(\lambda^{-2})$. If c is $0 (\lambda)$ or larger then the measurement is rejected because the incorporation of the measurement would destroy the ability to estimate expected values to an accuracy of $0(\lambda^{-2})$.

The novel parts of the measurement update are the approximating functions which preserve the ability to calculate expected values to an accuracy of $0(\lambda^{-2})$ and the test on the value of c to decide if a measurement should be accepted.

**Claims**

1. A filter for deriving estimates of parameters representative of the state of a system comprising means for making a sequence of related measurements of the state over a period of time, and means responsive thereto for generating an approximation to the optimal probability density function of the system in the form of a product of a linear function and a Gaussian function or of a product of a polynomial function and a Gaussian function.

2. A filter according to Claim 1 incorporating means for updating the approximation to the optimal probability density function in order to take account of the evolution of the system state.

3. A filter according to Claims 1 or 2 incorporating means for updating the approximation to the optimal probability density function in order to take account of measurements of the system state.

4. A filter according to Claim 1 wherein the approximating function M ($P$, $\mu$,m,x) is defined by

$$M \ (P, \ \mu,m,x) \ = \left( \frac{\lambda^n}{(2\pi)^n \det(P)} \right)^{1/2} \left(1 + \mu \ P^{-1}(x - m)\right) \exp \ -\left(\frac{\lambda}{2}(x - m)P^{-1}(x - m)\right)$$

where $\mu$,m are n dimensional vectors, P is a positive definite n x n matrix, and $\lambda$ is related to noise levels or in which the approximating function is chosen to have a similar behaviour at low noise levels.

5. A filter substantially as hereinbefore described.

```
                    ┌──────────────────────────┐
                    │  pdf for system state    │
                    │      at time k           │
                    └──────────────────────────┘
                                │
                                ▼
                    ┌──────────────────────────┐
                    │  pdf for system state    │
                    │     at time k + 1        │
                    └──────────────────────────┘
                                │
                                ▼
  ┌───────────────┐   ┌──────────────────────────┐
  │  measurement  │──▶│  pdf for system state at │
  └───────────────┘   │ time k + 1 incorporating │
                      │    the measurement       │
                      └──────────────────────────┘
```

European Patent
Office

**EUROPEAN SEARCH REPORT**

Application Number

EP 92 30 9464

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | IEEE TRANSACTIONS ON COMMUNICATIONS vol. 38, no. 7, July 1990, NEW YORK US pages 1060 - 1065 , XP159543 RAJIV VIJAYAN ET AL 'NONLINEAR TECHNIQUES FOR INTERFERENCE SUPPRESSION IN SPREAD-SPECTRUM SYSTEMS' * page 1061, column 1, line 22 - page 1062, column 1, line 13 * --- | 1-3 | H03H21/00 |
| A | IEEE TRANSACTIONS ON AUTOMATIC CONTROL vol. 28, no. 4, April 1983, NEW YORK US pages 497 - 503 C.H. KNAPP ET AL 'PARAMETER IDENTIFICATION IN A CLASS OF NONLINEAR SYSTEMS' * the whole document * ----- | 1-3 | |
| | | | **TECHNICAL FIELDS SEARCHED (Int. Cl.5 )** |
| | | | H03H |

The present search report has been drawn up for all claims

| Place of search | Date of completion of the search | Examiner |
|---|---|---|
| THE HAGUE | 04 FEBRUARY 1993 | COPPIETERS C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)